(19) **Europäisches Patentamt / European Patent Office / Office européen des brevets**

(11) **EP 4 572 574 B1**

(12) **FASCICULE DE BREVET EUROPEEN**

(45) Date de publication et mention
de la délivrance du brevet:
**17.06.2026 Bulletin 2026/25**

(21) Numéro de dépôt: **24218408.3**

(22) Date de dépôt: **09.12.2024**

(51) Classification Internationale des Brevets (IPC):
*H10H 29/01* (2025.01)  *H10H 29/30* (2025.01)
*H10H 29/80* (2025.01)  *H10H 29/851* (2025.01)
*H10K 59/38* (2023.01)  *H10F 39/10* (2025.01)

(52) Classification Coopérative des Brevets (CPC):
**H10K 59/38; H10F 39/107; H10H 29/012;
H10H 29/0361; H10H 29/30; H10H 29/842;
H10H 29/8514; H10H 29/8515;** H10H 29/8513;
H10W 90/00

(54) **PROCÉDÉ DE FABRICATION D'UN DISPOSITIF OPTOÉLECTRONIQUE À CONVERSION DE COULEUR PAR DÉPÔT LOCALISÉ DE PARTICULES PHOTOLUMINESCENTES SUR DES ZONES DE CONVERSION PRÉDÉFINIES À POTENTIEL DE SURFACE STRUCTURÉ**

VERFAHREN ZUR HERSTELLUNG EINER OPTOELEKTRONISCHEN VORRICHTUNG MIT FARBUMWANDLUNG DURCH LOKALISIERTE ABSCHEIDUNG VON LICHTEMITTIERENDEN PARTIKELN AUF VORBESTIMMTEN UMWANDLUNGSZONEN MIT STRUKTURPOTENTIAL

METHOD FOR MANUFACTURING AN OPTOELECTRONIC DEVICE WITH COLOR CONVERSION BY LOCALIZED DEPOSITION OF PHOTOLUMINESCENT PARTICLES ON PREDEFINED CONVERSION AREAS WITH STRUCTURED SURFACE POTENTIAL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.12.2023 FR 2314230**

(43) Date de publication de la demande:
**18.06.2025 Bulletin 2025/25**

(73) Titulaire: **Commissariat à l'Energie Atomique et aux Energies Alternatives
75015 Paris (FR)**

(72) Inventeurs:
• **ALTAZIN, Stéphane**
  **38054 Grenoble cedex 09 (FR)**
• **SUHM, Aurélien**
  **38054 Grenoble cedex 09 (FR)**
• **BILDE, Jeremy**
  **38054 Grenoble cedex 09 (FR)**
• **QUESNEL, Etienne**
  **38054 Grenoble cedex 09 (FR)**

(74) Mandataire: **Santarelli
Tour Trinity
1 bis Place de la Défense
92400 Courbevoie (FR)**

(56) Documents cités:
**WO-A1-2021/023656     DE-A1- 102004 021 231**

**Description**

## DOMAINE TECHNIQUE

Le domaine de l'invention est celui des procédés de fabrication des dispositifs optoélectroniques comportant une matrice de diodes d'émission ou de détection d'un rayonnement électroluminescent, associée à des plots de conversion de couleur. L'invention trouve une application notamment dans les écrans d'affichage et les projecteurs d'images.

## ÉTAT DE LA TECHNIQUE ANTÉRIEURE

Il existe des dispositifs optoélectroniques comportant une matrice de diodes électroluminescentes identiques recouvertes au moins en partie par des plots de conversion de couleur. De tels dispositifs optoélectroniques peuvent former des écrans d'affichage ou des systèmes de projection d'images comportant une matrice de pixels lumineux de différentes couleurs.

Dans un tel dispositif optoélectronique, chaque pixel lumineux comporte une ou plusieurs diodes électroluminescentes associées à un plot de conversion de couleur. Dans le but d'obtenir des pixels lumineux adaptés à émettre des rayonnements lumineux de différentes couleurs, par exemple bleues, vertes ou rouges, les diodes électroluminescentes peuvent être adaptées à émettre toute une même lumière, par exemple bleue, et les pixels verts et rouges comportent des plots de conversion de lumière adaptés à absorber au moins en partie la lumière bleue incidente, et à émettre en réponse une lumière verte ou une lumière rouge.

Les diodes électroluminescentes sont donc de préférence identiques entre elles, et émettent un rayonnement lumineux de même longueur d'onde. Elles peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une face avant au travers de laquelle est transmis le rayonnement lumineux généré.

Les plots de conversion de lumière peuvent être formés d'une matrice liante comportant des particules d'un matériau photoluminescent tel que le grenat d'yttrium et d'aluminium (YAG, pour *Yttrium Aluminium Garnet,* en anglais) activé par l'ion cérium YAG:Ce. Les particules photoluminescentes peuvent également être des boîtes quantiques *(quantum dots,* en anglais), c'est-à-dire sous la forme de nanocristaux semiconducteurs dont le confinement quantique est sensiblement tridimensionnel. Il peut également s'agir de nanoplaquettes (*nanoplatelets,* en anglais), c'est-à-dire des nanoparticules ayant une forme essentiellement bidimensionnelle (confinement quantique bidimensionnel).

Le procédé de fabrication peut comporter le dépôt puis la structuration d'une couche photoluminescente pour former des premiers plots de conversion de lumière, par exemple adaptés à convertir le bleu en rouge. Ces étapes sont effectuées à nouveau pour former des deuxièmes plots de conversion de lumière, par exemple adaptés à convertir le bleu en vert. Cependant, ce procédé présente l'inconvénient d'être peu adapté aux matrices de diodes à faible pas de pixels, par exemple de l'ordre de 5 $\mu$m, dans la mesure où des problèmes d'alignement ou de recouvrement des plots de conversion de lumière les unes par les autres peuvent être présents.

Le document WO2014/136023A1 décrit un autre procédé de fabrication, qui utilise une couche électret recouvrant la matrice de diodes. Le procédé comprend tout d'abord une étape d'inscription de motifs de charges électriques sur la face supérieure d'une couche diélectrique pour obtenir la couche électret alors chargée localement. Pour cela, une pointe AFM (pour *Atomic Force Microscopy,* en anglais) polarisée est utilisée pour injecter localement les charges électriques. Puis, on effectue une étape de dépôt localisé de nanocristaux colloïdaux sur les motifs de charges électriques. Pour cela, la couche électret est mise au contact d'une solution colloïdale contenant les nanocristaux, lesquels viennent se déposer naturellement sur les motifs de charges électriques sous l'effet d'une force diélectrophorétique. Cependant, ce procédé présente notamment l'inconvénient de devoir injecter les charges électriques de manière séquentielle, en déplaçant la pointe AFM sur la surface de la face supérieure pour y former les motifs de charges électriques.

Le document WO2021/023656A1 décrit un procédé similaire, où les motifs de charges électriques sont définis par une technique d'estampage, c'est-à-dire par la mise au contact, avec une couche diélectrique destinée à former la couche électret, d'un tampon polarisé électriquement. La face inférieure du tampon est structurée pour former des dents polarisées, lesquelles viennent au contact de la couche diélectrique. On obtient ainsi la couche électret dont la face supérieure présente les motifs de charges électriques. Ensuite, on met la couche électret au contact d'une solution colloïdale, les nanocristaux présents se déposant alors sur les motifs de charges électriques par diélectrophorèse. Cependant, ce procédé présente notamment l'inconvénient de devoir positionner précisément le tampon vis-à-vis de la matrice de diodes. Or, l'incertitude de positionnement du tampon vis-à-vis de la matrice de diodes peut devenir problématique, en particulier pour les matrices de diodes à petit pas pixel, par exemple de l'ordre de 5 $\mu$m. En effet, cette incertitude ou imprécision de positionnement peut conduire à un mauvais positionnement des plots de conversion de lumière vis-à-vis des diodes, et donc à une dégradation des performances du dispositif optoélectronique.

Le document DE 10 2004 021231 A1 décrit une méthode de dépôt d'un matériau sur un corps solide, où des forces électrostatiques s'exercent entre le matériau et ledit corps solide lors dudit dépôt. Ledit matériau contient au moins un agent photoluminescent de conversion de lumière. Ce procédé est particulièrement adapté au revêtement de composants optoélectroniques par une couche de conversion de lumière.

## EXPOSÉ DE L'INVENTION

L'invention a pour objectif de remédier au moins en partie aux inconvénients de l'art antérieur, et plus particulièrement de proposer un procédé de fabrication d'un dispositif optoélectronique qui présente des performances améliorées.

Pour cela, l'objet de l'invention est un procédé de fabrication d'un dispositif optoélectronique, comportant les étapes suivantes :

- fournir une matrice de diodes, présentant une face avant destinée à recevoir ou transmettre un rayonnement lumineux ;
- réaliser une couche électret, s'étendant sur la face avant de la matrice de diodes, dont une face supérieure, opposée à la face avant, présente des zones de conversion, chacune étant située à la perpendiculaire d'une diode et destinée à être recouverte par un plot de conversion de couleur, séparées deux à deux par une zone d'espacement à potentiel de surface nul ;
- réaliser les plots de conversion de couleur, par mise en contact de la couche électret avec une solution colloïdale contenant des particules photoluminescentes, lesquelles se déposent sur la couche électret dans les zones de conversion, formant ainsi les plots de conversion de couleur ;
- à la suite de l'étape de réalisation de la couche électret, chaque zone de conversion est formée d'une pluralité de zones élémentaires dites polarisées à potentiel de surface non nul espacées deux à deux par une zone élémentaire dite non polarisée à potentiel de surface nul, de sorte que la zone de conversion présente un potentiel de surface structuré.

Certains aspects préférés, mais non limitatifs de ce procédé sont les suivants.

Les zones élémentaires polarisées peuvent être agencées de manière symétrique vis-à-vis d'un centre de la zone de conversion.

Chaque zone de conversion peut comporter entre trois et neuf zones élémentaires polarisées, et de préférence entre trois et sept zones élémentaires polarisées.

Les zones élémentaires polarisées peuvent toutes être situées à distance d'une bordure de la zone de conversion.

La couche électret peut présenter une permittivité relative homogène.

La couche électret peut présenter une permittivité relative présentant une première valeur dans les zones de conversion et une deuxième valeur supérieure à la première valeur hors des zones de conversion.

La couche électret peut être formée de premières portions situées dans les zones de conversion et réalisées en un matériau présentant la première valeur de permittivité relative, et des deuxièmes portions situées hors des zones de conversion et réalisées en un matériau présentant la deuxième valeur de permittivité relative.

La couche électret peut être formée d'une sous-couche continue recouvrant la matrice de diodes et réalisée en un matériau présentant la première valeur de permittivité relative, et de portions recouvrant la sous-couche, situées hors des zones de conversion et réalisées en un matériau présentant la deuxième valeur de permittivité relative.

L'invention porte également sur un dispositif optoélectronique, comportant :

- une matrice de diodes présentant une face avant destinée à recevoir ou transmettre un rayonnement lumineux ;
- une couche électret, s'étendant sur la face avant de la matrice de diodes, dont une face supérieure, opposée à la face avant, présente des zones de conversion, chacune étant située à la perpendiculaire d'une diode et destinée à être recouverte par un plot de conversion de couleur, séparées deux à deux par une zone d'espacement à potentiel de surface nul ;
- des plots de conversion de couleur, situés sur la couche électret et positionnés dans les zones de conversion ;
- où chaque zone de conversion est formée d'une pluralité de zones élémentaires dites polarisées à potentiel de surface non nul espacées deux à deux par une zone élémentaire dite non polarisée à potentiel de surface nul, de sorte que la zone de conversion présente un potentiel de surface structuré.

Les diodes peuvent présenter des propriétés d'émission ou d'absorption d'un rayonnement lumineux identiques entre elles.

3

Les diodes peuvent être réalisées à base d'un composé semiconducteur organique ou inorganique.

Il est également question d'un procédé de fabrication d'un dispositif optoélectronique, comportant les étapes suivantes :

○ fournir une matrice de diodes, présentant une face avant destinée à recevoir ou transmettre un rayonnement lumineux ;

○ réaliser une couche électret, s'étendant sur la face avant de la matrice de diodes, dont une face supérieure, opposée à la face avant, présente des zones de conversion, chacune étant située à la perpendiculaire d'une diode et destinée à être recouverte par un plot de conversion P de couleur, séparées deux à deux par une zone d'espacement à potentiel de surface nul ;

○ réaliser les plots de conversion de couleur, par mise en contact de la couche électret avec une solution colloïdale contenant des particules photoluminescentes, lesquelles se déposent sur la couche électret dans les zones de conversion, formant ainsi les plots de conversion de couleur ;

○ à la suite de la réalisation de la couche électret : le potentiel de surface dans chaque zone de conversion est uniformément non nul ; les zones de conversion présentent une première valeur de permittivité relative et les zones d'espacement présentent une deuxième valeur de permittivité relative supérieure à la première valeur.

La couche électret peut être formée de premières portions situées dans les zones de conversion et réalisées en un matériau présentant la première valeur de permittivité relative, et des deuxièmes portions situées hors des zones de conversion et réalisées en un matériau présentant la deuxième valeur de permittivité relative.

La couche électret peut être formée d'une sous-couche continue recouvrant la matrice de diodes et réalisée en un matériau présentant la première valeur de permittivité relative, et de portions recouvrant la sous-couche, situées hors des zones de conversion et réalisées en un matériau présentant la deuxième valeur de permittivité relative.

Il est également question d'un dispositif optoélectronique, comportant :

○ une matrice de diodes présentant une face avant destinée à recevoir ou transmettre un rayonnement lumineux ;

○ une couche électret, s'étendant sur la face avant de la matrice de diodes, dont une face supérieure, opposée à la face avant, présente des zones de conversion, chacune étant située à la perpendiculaire d'une diode et destinée à être recouverte par un plot de conversion de couleur, séparées deux à deux par une zone d'espacement à potentiel de surface nul ;

○ des plots de conversion de couleur, situés sur la couche électret et positionnés dans les zones de conversion ;

○ où le potentiel de surface dans chaque zone de conversion est uniformément non nul ; les zones de conversion présentent une première valeur de permittivité relative et les zones d'espacement présentent une deuxième valeur de permittivité relative supérieure à la première valeur.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

les figures 1A à 1C illustrent différentes étapes d'un procédé de fabrication d'un dispositif optoélectronique où les zones de conversion présentent un potentiel de surface uniformément non nul ;

la figure 2 illustre une variation de la composante verticale du gradient du champ électrique, dans la configuration de la fig.1B ;

la figure 3A est une vue schématique et partielle, en coupe transversale, d'un dispositif optoélectronique où les zones de conversion présentent un potentiel de surface uniformément non nul, selon un autre agencement de la matrice de diodes ;

la figure 3B illustre une variation de la composante verticale du gradient du champ électrique, dans la configuration de la fig.3A ;

la figure 4A est une vue schématique et partielle, en coupe transversale, d'un dispositif optoélectronique selon un mode de réalisation où les zones de conversion présentent un potentiel de surface structuré ;

la figure 4B est une vue de dessus de la zone de conversion illustrant l'agencement des zones élémentaires polarisées ;

la figure 4C illustre une variation de la composante verticale du gradient du champ électrique, dans la configuration de la fig.4A ;

la figure 5A est une vue schématique et partielle, en coupe transversale, d'un dispositif optoélectronique selon un autre mode de réalisation où les zones de conversion présentent un potentiel de surface structuré ;

la figure 5B illustre une variation de la composante verticale du gradient du champ électrique, dans la configuration de la fig.5A ;

les figures 6A à 6F sont des vues de dessus d'une zone de conversion d'un dispositif optoélectronique selon différents modes de réalisation ;

les figures 7A à 7C illustrent la variation de la composante verticale du gradient du champ électrique, pour différents modes de réalisation du dispositif optoélectronique ;

la figure 8A illustre une variation de la composante verticale du gradient du champ électrique, pour un dispositif optoélectronique selon un mode de réalisation où la couche électret présente une permittivité relative homogène ;

la figure 8B est une vue schématique et partielle, en coupe transversale, d'un dispositif optoélectronique selon un mode de réalisation où la couche électret présente une permittivité relative inhomogène ;

la figure 8C illustre une variation de la composante verticale du gradient du champ électrique, pour la configuration de la fig.8B ;

la figure 9A est une vue schématique et partielle, en coupe transversale, d'un dispositif optoélectronique selon un mode de réalisation, ne faisant pas partie de la présente invention telle que définie par les revendications en annexe mais étant utile pour comprendre son contexte, où la couche électret présente une permittivité relative inhomogène et où les zones de conversion présentent un potentiel de surface uniformément non nul ;

la figure 9B illustre une variation de la composante verticale du gradient du champ électrique, pour la configuration de la fig.9A ;

la figure 10A est une vue schématique et partielle, en coupe transversale, d'un dispositif optoélectronique selon un autre mode de réalisation, ne faisant pas non plus partie de la présente invention telle que définie par les revendications en annexe mais étant utile pour comprendre son contexte, où la couche électret présente une permittivité relative inhomogène et où les zones de conversion présentent un potentiel de surface uniformément non nul ;

la figure 10B illustre une variation de la composante verticale du gradient du champ électrique, pour la configuration de la fig.10A ;

les figures 11A à 11E illustrent différentes étapes d'un procédé de fabrication d'un dispositif optoélectronique similaire à celui de la fig.9A.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique comportant une matrice de diodes, dont au moins une partie des diodes est recouverte par des plots de conversion de couleur, de manière à former une matrice de pixels lumineux de différentes couleurs. Les diodes peuvent être des diodes émissives de sorte que le dispositif optoélectronique peut être par exemple un écran d'affichage. Elles peuvent ainsi être des diodes électroluminescentes de type organique (OLED) ou inorganique (LED). En variante, les diodes peuvent être détectrices de sorte que le dispositif optoélectronique peut être un photodétecteur matriciel. Il peut s'agir de photodétecteurs organiques ou inorganiques.

La réalisation des plots de conversion de couleur est obtenue par le dépôt localisé de particules photoluminescentes sur une couche électret. Chaque plot de conversion est situé en regard d'une diode.

D'une manière générale, une couche électret est une couche diélectrique contenant des charges électriques ou une polarisation dipolaire quasi-permanente. Aussi, la couche électret présente, sur au moins une partie de sa face supérieure, un potentiel de surface non nul. Cela se traduit par le fait que la couche électret émet un champ électrique externe en l'absence d'un champ appliqué.

Dans le cadre de l'invention, on définit une zone de conversion comme étant une surface prédéfinie de la couche électret située à la perpendiculaire d'une diode, et recouverte ou destinée à être recouverte par un plot de conversion. Le potentiel de surface, dans une telle zone de conversion, n'est pas uniformément non nul comme dans l'art antérieur (c'est-à-dire non nul sur toute la surface de la zone de conversion), mais y est structuré. Autrement dit, chaque zone de conversion est formée de plusieurs zones élémentaires dites polarisées où le potentiel de surface est non nul, espacées deux à deux par une zone élémentaire non polarisée où le potentiel de surface est nul.

Ainsi, il apparaît que le dépôt localisé des particules photoluminescentes dans la zone de conversion y est davantage homogène que dans l'art antérieur, améliorant ainsi les propriétés du dispositif optoélectronique. De plus, il apparaît que le dépôt localisé des particules photoluminescentes hors des zones de conversion est diminué, ce qui améliore le contraste des pixels du dispositif optoélectronique.

D'une manière générale, les plots de conversion de couleur sont formés de particules en au moins un matériau photoluminescent, et de préférence de nanoparticules dont au moins une dimension maximale est comprise entre 0.2nm et 1000nm, par exemple comprise entre 20nm et quelques centaines de nanomètres. La taille et/ou la composition des particules photoluminescentes sont choisies en fonction de la longueur d'onde de luminescence désirée. La forme des particules peut être quelconque, par exemple sphérique, anguleuse, aplatie, allongée...

Les particules photoluminescentes peuvent être des boîtes quantiques (quantum dots, en anglais), c'est-à-dire des nanocristaux semiconducteurs dont le confinement quantique est sensiblement tridimensionnel . La taille moyenne des boîtes quantiques peut alors être comprise entre 0,2nm et 50nm, par exemple entre 1nm et 30nm. Il peut également s'agir de nanoplaquettes (*nanoplatelets,* en anglais), c'est-à-dire des nanoparticules ayant une forme essentiellement bidimensionnelle, avec une longueur qui peut être de l'ordre de 20nm à quelques centaines de nanomètres. Aussi, la plus petite dimension (épaisseur) est inférieure aux deux autres dimensions de longueur et de largeur, de préférence d'un rapport au moins 1.5.

Les particules photoluminescentes peuvent notamment être formées d'au moins un composé semiconducteur, qui peut être choisi, par exemple, parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. Les nanoparticules peuvent également présenter une structure de type cœur/coquille, telle que CdSe/ZnS, CdSe/CdS, CdSe/CdS/ZnS, PbSe/PbS, CdTe/CdSe, CdSe/ZnTe, InP/ZnS ou autre. Les particules peuvent également présenter une structure cristalline pérovskite comportant des atomes tels que ceux listés pour les nanoparticules, mais également Cs, Mn, Br.

Par ailleurs, les plots de conversion de lumière sont adaptés à convertir au moins en partie un rayonnement lumineux incident d'une première longueur d'onde $\lambda_1$ en un rayonnement lumineux de luminescence de plus grande longueur d'onde $\lambda_2$. A titre illustratif, elles peuvent être adaptées à absorber de la lumière bleue, c'est-à-dire dont la longueur d'onde est comprise entre 440nm et 490nm environ, et à émettre dans le vert, c'est-à-dire à une longueur d'onde comprise entre 495nm et 560nm environ, voire dans le rouge, c'est-à-dire à une longueur d'onde comprise entre 600nm et 650nm. Par longueur d'onde, on entend ici la longueur d'onde à laquelle le spectre d'émission présente un pic d'intensité.

A titre purement illustratif, les diodes peuvent être émissives et présenter un spectre d'émission dans le visible ou l'infrarouge (par exemple dans le NIR ou le SWIR), ou même ultraviolet (200-400 nm). Dans le cas d'une matrice de diodes émissives, le rayonnement lumineux incident est le rayonnement émis par les diodes, alors que dans le cas de photodiodes, il s'agit du rayonnement lumineux provenant d'un environnement extérieur et dirigé vers les photodiodes. Dans ce dernier cas, les diodes sont alors adaptées à absorber des rayonnements lumineux incidents de différentes longueurs d'onde toutes contenues dans un même spectre d'absorption prédéfini.

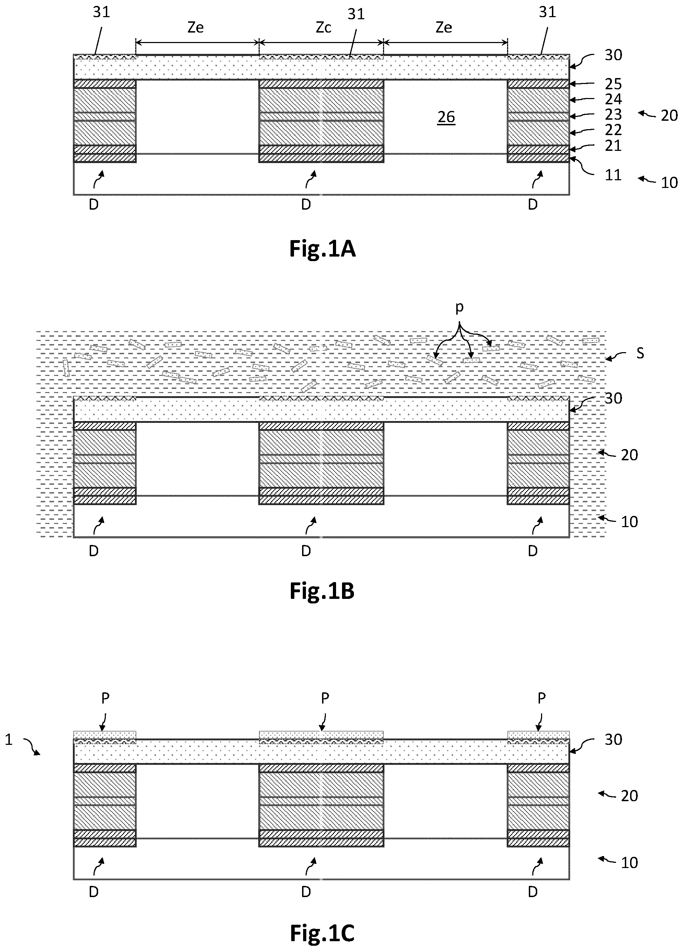

Les figures 1A à 1C illustrent différentes étapes d'un exemple de procédé de fabrication d'un dispositif optoélectronique 1, permettant de mettre en évidence une problématique liée au dépôt localisé des particules photoluminescentes p dans la zone de conversion Zc et hors de la zone de conversion Zc. Dans cet exemple, les diodes D sont des diodes électroluminescentes.

On définit ici et pour la suite de la description un repère direct tridimensionnel orthogonal XYZ, où les axes X et Y forment un plan principal dans lequel s'étend la matrice de diodes 20, et où l'axe Z est orienté suivant l'épaisseur de la matrice de diodes 20 en direction de la face avant. Les termes 'inférieur' et 'supérieur' sont définis par rapport à un positionnement croissant suivant la direction +Z.

En référence à la fig.1A, on fournit la matrice 20 de diodes électroluminescentes D. Les diodes D reposent ici sur un substrat de commande 10, et sont polarisées électriquement ici par une ou plusieurs couches d'électrode inférieure 21 et par une ou plusieurs couches d'électrode supérieure 25. D'autres configurations sont possibles, notamment dans le cas où le substrat de commande 10 est électriquement conducteur. La matrice de diodes 20 présente une face arrière, par laquelle elle est assemblée et connectée au substrat de commande 10, et une face avant, opposée à la face arrière, qui est destinée à recevoir ou transmettre un rayonnement lumineux. Dans cet exemple où les diodes D sont émissives, la face avant transmet le rayonnement lumineux émis par les diodes. Dans cet exemple, on prévoit de réaliser des plots de conversion de couleur au-dessus des diodes représentées. Mais certaines diodes peuvent ne pas être associées à des plots de conversion de couleur.

Dans cet exemple, le substrat de commande 10 comporte un circuit de commande de type CMOS (non représenté), et présente des plots de connexion électrique 11 qui affleurent la face supérieure et viennent au contact de couches d'électrode inférieure 21 des diodes D. Ces couches d'électrode inférieure 21 sont ici des couches distinctes les unes des autres, dans le sens où chaque couche d'électrode inférieure 21 d'une diode D est physiquement distincte de celle de la diode adjacente. Cette configuration est décrite en détail dans le document WO2017/194845 A1. D'autres configurations sont possibles.

Les diodes D sont ici des diodes électroluminescentes inorganiques. Elles peuvent être réalisées de manière classique, par exemple par épitaxie de couches semiconductrices à partir d'un substrat de croissance, puis par report sur le substrat de commande 10. Chaque diode D peut être formée d'un empilement de : une portion semiconductrice inférieure 22 (située du côté du substrat de commande) dopée d'un premier type de conductivité, par exemple de type p, en contact électrique avec une couche d'électrode inférieure 21; une zone active 23 où est émis le rayonnement lumineux de la diode électroluminescente ; et une portion semiconductrice supérieure 24 dopée d'un deuxième type de conductivité, par exemple de type n, en contact électrique avec une couche d'électrode supérieure 25. Les diodes D peuvent être réalisées à partir d'un même composé semiconducteur, par exemple à base d'un composé III-V tel que du GaN, InGaN, AlGaN. Un matériau de remplissage 26, électriquement isolant, remplit l'espace situé entre les diodes D.

De préférence, les diodes D sont structurellement identiques, de sorte que le rayonnement lumineux émis est identique d'une diode à l'autre en termes de longueur d'onde. Dans cet exemple, les diodes D sont adaptées à émettre un rayonnement lumineux dans le bleu, c'est-à-dire dont le spectre d'émission présente un pic d'intensité à une longueur d'onde comprise entre 440nm et 490nm environ.

La face avant de la matrice de diodes 20 est recouverte par une couche électret 30. La couche électret 30 est réalisée en au moins un matériau diélectrique, par exemple inorganique, tel qu'un oxyde, nitrure ou oxynitrure de silicium, par exemple du $SiO_2$, $Si_3N_4$, $Al_2O_3$ (notamment dans le cas d'OLED), entre autres. Elle peut présenter une épaisseur de l'ordre de quelques centaines de nanomètres, par exemple 400nm environ. Notons que des matériaux diélectriques organiques peuvent également convenir, comme par exemple le PMMA, PVDF, PET, COC etc.

On définit une zone de conversion Zc comme étant une surface de la couche électret 30 située en regard (à la perpendiculaire) d'une diode D, et plus précisément de sa couche active 23. Dans cet exemple, le potentiel de surface 31 y est uniformément non nul (i.e. non nul sur toute la surface de la zone Zc). Les zones de conversion Zc sont séparées latéralement deux à deux par une zone d'espacement Ze où le potentiel de surface y est nul (plus précisément, le potentiel de surface de chaque zone d'espacement Ze est uniformément nul, c'est-à-dire nul sur toute la surface de la zone Ze).

La formation des zones de conversion Zc, i.e. la formation du potentiel de surface non nul 31 dans les zones de conversion Zc, peut être réalisée de différentes manières. On peut utiliser une pointe AFM comme dans le document WO2014/136023A1 ou une technique d'estampage comme dans le document WO2021/023656A1. On peut également dépolariser localement une couche électret 30 dont le potentiel de surface est initialement non nul sur toute la face avant, par voie optique, au moyen d'une activation des diodes, comme décrit dans la demande de brevet FR2308637 déposée le 10/08/2023. On peut également effectuer localement une polarisation électrostatique de la couche électret dont le potentiel de surface est initialement nul sur toute la face avant, au moyen d'une activation des électrodes supérieures, comme décrit dans la demande de brevet FR2309260 déposée le 04/09/2023.

Ainsi, les zones de conversion Zc à potentiel de surface 31 uniformément non nul sont présentes uniquement en regard des diodes D. Autrement dit, la couche électret 30 présente un potentiel de surface nul partout, sauf dans les zones de conversion Zc en regard des diodes.

En référence à la fig.1B, on réalise ensuite les plots de conversion de couleur, par dépôt localisé de particules photoluminescentes p sur la couche électret 30 sur les zones de conversion Zc. Pour cela, on opère d'une manière similaire à ce qui est décrit dans les documents WO2014/136023A1 et WO2021/023656A1. Ainsi, on met une solution colloïdale S contenant les particules photoluminescentes p au contact de la face supérieure de la couche électret 30. Les particules photoluminescentes p sont adaptées à convertir la lumière bleue en, par exemple, une lumière rouge. On peut ainsi plonger tout l'empilement dans la solution colloïdale S, ou déposer une goutte d'une telle solution sur la couche électret 30. Du fait du potentiel de surface 31 non nul situé dans les zones de conversion Zc, un champ électrique non uniforme est généré qui provoque un dépôt localisé des particules photoluminescentes p par diélectrophorèse. Aussi, les particules photoluminescentes p se déposent essentiellement sur les zones de conversion Zc (et donc en regard des diodes). Le temps de contact de la solution colloïdale S sur la couche électret 30 dépend notamment de la quantité de particules photoluminescentes p à déposer et donc de l'épaisseur souhaitée des plots de conversion P, ainsi que de la valeur du potentiel de surface. A titre d'exemple, l'épaisseur des plots de conversion P peut être de l'ordre de quelques centaines de nanomètres, par exemple égale à 400nm environ. On retire ensuite la solution colloïdale S et on peut sécher la couche électret 30.

En référence à la fig.1C, on obtient un dispositif optoélectronique 1 où les plots de conversion P sont présents essentiellement dans les zones de conversion Zc, et donc en regard des diodes D. Une encapsulation en couche fine (par ex. en $Al_2O_3$) des plots de conversion P peut ensuite être effectuée (non représenté).

On peut ensuite réitérer les étapes précédentes pour réaliser d'autres plots de conversion de couleur situés en regard d'autres diodes, formant par exemple des pixels verts. En effet, les plots de conversion de couleur précédemment décrits sont adaptés à convertir une lumière bleue (longueur d'onde comprise entre 440nm et 490nm environ) en une lumière rouge (longueur d'onde comprise entre 600nm et 650nm). En revanche, les plots de conversion de couleur sont adaptés ici à convertir la lumière bleue en une lumière verte (longueur d'onde comprise entre 495nm et 560nm environ).

Cependant, il apparaît que les particules photoluminescentes p peuvent ne pas se déposer de manière homogène dans les zones de conversion Zc, ce qui conduit à former des plots de conversion P dont l'épaisseur de chacun est non uniforme, de sorte que les propriétés de conversion des plots P ne sont pas spatialement uniformes. De plus, il apparaît que les particules photoluminescentes p peuvent se déposer hors des zones de conversion Zc, dégradant ainsi le contraste associé à chaque pixel émissif.

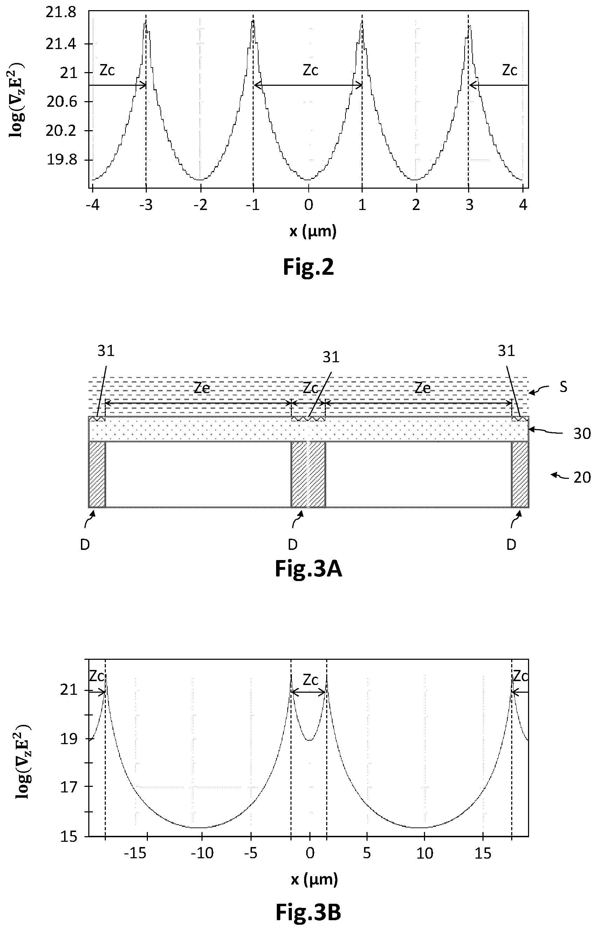

La figure 2 illustre la variation spatiale de l'intensité (en log) de la composante verticale $\nabla_z E^2$ du gradient de la norme au carré du champ électrique E, dont est proportionnelle la force diélectrophorétique F, calculée à une distance de 100nm au-dessus de la couche électret 30, dans une configuration structurelle similaire à celle de la fig.1B.

D'une manière générale, une particule photoluminescente de dimension r et de constante diélectrique $\varepsilon_p$ située dans une solution de constante diélectrique $\varepsilon_m$ (permittivité diélectrique) subit, du fait de l'inhomogénéité spatiale du champ électrique $\vec{E}$, une force diélectrophorétique $\vec{F}$ définie par la relation :

$$\vec{F} = 2 \times \pi \times r^3 \times \varepsilon_m \times \frac{\varepsilon_p - \varepsilon_m}{\varepsilon_p + 2 \times \varepsilon_m} \times \nabla\left(\left\|\vec{E}\right\|^2\right)$$

Dans cette configuration, les diodes D présentent une dimension latérale de 2µm et sont agencées périodiquement au pas de 4µm. Aussi, les zones de conversion Zc présentent une dimension latérale de 2µm et sont espacées de 2µm les unes des autres. Le potentiel de surface 31 est uniformément non nul dans les zones de conversion Zc, et est uniformément nul dans les zones d'espacement Ze. Le facteur de remplissage $FF_d$ des diodes est ici égal à 50% (=2µm/4µm).

On considère par ailleurs une permittivité relative $\varepsilon_{r,e}$ de la couche électret 30 qui est homogène (spatialement uniforme) dans toute la couche et égale à 4, et une permittivité relative $\varepsilon_{r,m}$ de la solution colloïdale également homogène et égale à 2.

Il apparaît que la force diélectrophorétique $F_z$ n'est pas constante dans les zones de conversion Zc. En effet, elle présente un maximum, situé à la bordure de la zone de conversion Zc, d'une valeur ici de 21.7, et un minimum situé au centre de la zone de conversion Zc, d'une valeur ici de 19.5.

De plus, l'intensité de la force $F_z$ décroît en dehors de la zone de conversion Zc, jusqu'à un minimum de 19.5 également situé au centre de la zone d'espacement Ze. Il apparaît de plus que ces minima de la force diélectrophorétique $F_z$ sont situés à la même distance de la bordure de la zone de conversion Zc, de sorte que le taux de décroissance est symétrique de part et d'autre de cette bordure. En conséquence, la variation de la force $F_z$ est identique dans les zones de conversion Zc et dans les zones d'espacement Ze, de sorte que, du point de vue de la force diélectrophorétique, il n'est pas possible de distinguer les zones de conversion Zc des zones d'espacement Ze.

Aussi, les particules photoluminescentes p se déposent davantage sur la bordure de la zone de conversion Zc, puis de part et d'autre de celle-ci de manière sensiblement symétrique.

Cela conduit à former des plots de conversion P qui, non seulement ne présentent pas une épaisseur uniforme dans les zones de conversion Zc, mais, de plus, qui ne sont pas correctement positionnés. Les propriétés de conversion sont alors dégradées, et le contraste des pixels lumineux n'est pas optimal.

La figure 3A est une vue schématique et partielle, en coupe transversale, d'une matrice de diodes 20 recouverte par une couche électret 30, et par une solution colloïdale S (les particules photoluminescentes p ne sont pas représentées), dans une autre configuration structurelle. Comme pour la fig.1B, la couche électret 30 comporte des zones de conversion Zc situées à la perpendiculaire des diodes D, où le potentiel de surface 31 est uniformément non nul (i.e. non nul sur toute la surface de la zone Zc), séparées deux à deux par des zones d'espacement Ze à potentiel de surface uniformément nul (i.e. nul sur toute la surface de la zone Ze).

Les zones de conversion Zc présentent une dimension latérale de 2µm, et sont agencées périodiquement au pas de 18µm. Aussi, les zones d'espacement Ze présentent une dimension latérale de 16µm. Le facteur de remplissage $FF_d$ est donc de 11% (=2µm/18µm). Dans cet exemple, la couche électret 30 présente une permittivité relative homogène égale à 4, et la solution colloïdale S présente une permittivité relative homogène égale à 2.

La figure 3B illustre la variation spatiale de l'intensité (en log) de la composante verticale $\nabla_z E^2$ du gradient de la norme au carré du champ électrique E, dont est proportionnelle la force diélectrophorétique F, calculée à une distance de 100nm au-dessus de la couche électret 30, dans la configuration structurelle de la fig.3B.

Comme pour la fig.2, il apparaît que la force diélectrophorétique $F_z$ n'est pas constante dans les zones de conversion Zc. En effet, elle présente un maximum, situé à la bordure de la zone de conversion Zc, d'une valeur ici, en $\log(V_z E^2)$, de 21.8, et un minimum, situé au centre de la zone de conversion Zc, d'une valeur ici de 18.9.

De plus, l'intensité de la force $F_z$ décroît en dehors de la zone de conversion Zc, jusqu'à un minimum de 15.4 au centre de la zone d'espacement Ze. Ce minimum est donc largement inférieur à celui présent dans la zone de conversion Zc.

Dans la mesure où le centre de la zone d'espacement Ze est plus éloigné de la bordure, la force $F_z$ présente, dans la zone d'espacement, un taux de décroissance à partir du maximum de 21.8 légèrement plus élevé que celui défini dans la zone de conversion Zc.

Aussi, bien que les particules photoluminescentes p se déposeront principalement dans la zone de conversion Zc, un dépôt aura lieu malgré tout dans la zone d'espacement Ze, à partir de la bordure de la zone de conversion Zc. De plus, le dépôt localisé dans la zone de conversion Zc n'est pas uniforme : il sera plus important au niveau de la bordure qu'au centre de la zone de conversion Zc, conduisant à un taux de conversion non uniforme.

Les inventeurs ont mis en évidence que le fait de structurer le potentiel de surface dans les zones de conversion Zc permet de limiter les inconvénients des configurations qui viennent d'être présentées. Le potentiel de surface est dit structuré dans la mesure où chaque zone de conversion Zc présente plusieurs zones élémentaires 32 à potentiel de surface non nul (plus précisément uniformément non nul, c'est-à-dire non nul sur toute la surface de la zone 32) espacées deux à deux par une zone élémentaire 33 à potentiel de surface nul (plus précisément uniformément nul, c'est-à-dire nul sur toute la surface de la zone 33). On se distingue ainsi des zones de conversion Zc des fig.1A à 1C où le potentiel de surface est uniformément non nul, i.e. non nul sur toute la surface de la zone Zc.

En effet, un potentiel de surface structuré va permettre d'améliorer l'homogénéité du dépôt localisé des particules photoluminescentes p dans la zone de conversion Zc, et donc l'épaisseur du plot de conversion P, tout en limitant le dépôt hors des zones de conversion Zc (donc en différenciant, en termes de force diélectrophorétique, les zones de conversion Zc des zones d'espacement Ze).

Ainsi, une zone élémentaire dite polarisée 32 est une partie de la surface de la zone de conversion Zc où le potentiel de surface est non nul sur toute la surface de la zone 32 (donc uniformément non nul). De plus, une zone élémentaire dite non polarisée 33 est une partie de la surface de la zone de conversion Zc où le potentiel de surface est nul sur toute la surface de la zone 33 (donc uniformément nul). Aussi, chaque zone de conversion Zc est formée de plusieurs zones élémentaires polarisées 32 séparées deux à deux par une zone élémentaire non polarisée 33.

Dans chaque zone de conversion Zc, les zones élémentaires polarisées 32 sont agencées de préférence de manière symétrique vis-à-vis d'un axe contenu dans le plan XY et passant par le centre de la zone de conversion Zc. A titre d'exemple, les zones élémentaires polarisées 32 peuvent être agencées de manière symétrique vis-à-vis de l'axe X et/ou de l'axe Y.

Suivant un même axe du plan XY, par exemple suivant l'axe X, chaque zone de conversion Zc peut comporter au moins deux zones élémentaires polarisées 32, par exemple entre deux et vingt zones élémentaires polarisées 32. De préférence, elle comporte entre trois et neuf zones élémentaires polarisées 32, voire de préférence entre trois et sept zones élémentaires polarisées 32. Ainsi, on améliore l'homogénéité du dépôt localisé des particules photoluminescentes p dans la zone de conversion Zc. Les zones élémentaires polarisées 32 peuvent présenter une dimension par exemple de l'ordre de $1/5^e$, $1/10^e$, voire $1/20^e$ de la dimension de la zone de conversion Zc suivant le même axe considéré (par exemple suivant l'axe X). Ainsi, à titre d'exemple, pour une zone de conversion Zc de $2\mu m$ de largeur, les zones élémentaires polarisées 32 peuvent présenter une largeur de 100 à 500nm environ. Les zones élémentaires non polarisées 33 peuvent présenter une largeur du même ordre.

Les zones élémentaires polarisées 32 peuvent être agencées dans chaque zone de conversion Zc à partir de la bordure de celle-ci, c'est-à-dire en étant accolées à celle-ci. En variante, elles peuvent ne pas être accolées à la bordure, mais peuvent en être espacées. Cette configuration est avantageuse, car elle permet d'éviter que la force diélectrophorétique présente un pic d'intensité situé au niveau de la bordure, ce qui limite le dépôt des particules photoluminescentes p dans la zone d'espacement à proximité de la bordure. On améliore ainsi le contraste des pixels lumineux.

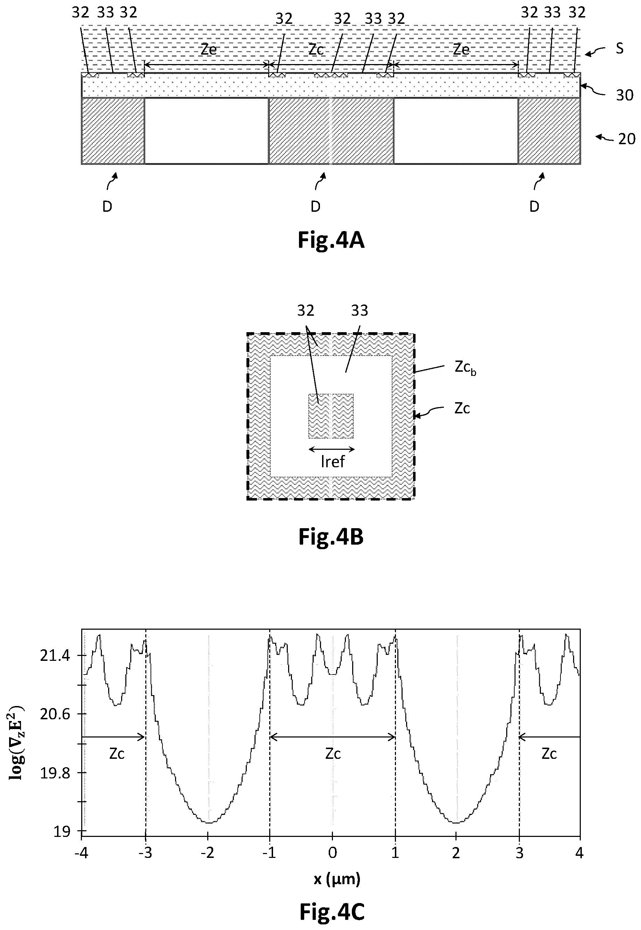

La figure 4A est une vue schématique et partielle, en coupe transversale, d'une matrice de diodes recouverte par une couche électret, laquelle est au contact d'une solution colloïdale. La figure 4B est une vue de dessus de l'agencement des zones élémentaires polarisées 32 situées dans une zone de conversion Zc. La figure 4C illustre la variation spatiale de l'intensité (en log) de la composante verticale $\nabla_z E^2$ du gradient de la norme au carré du champ électrique E, dont est proportionnelle la force diélectrophorétique F, calculée à une distance de 100nm au-dessus de la couche électret 30, dans la configuration structurelle de la fig.4A.

Dans cette configuration, les diodes D présentent une dimension latérale de $2\mu m$ et sont agencées périodiquement au pas de $4\mu m$. Aussi, les zones de conversion Zc présentent une dimension latérale de $2\mu m$ et sont espacées de $2\mu m$ les unes des autres. La couche électret 30 présente une permittivité relative homogène égale à 4, et la solution colloïdale S présente une permittivité relative homogène égale à 2.

Chaque zone de conversion Zc comporte une zone élémentaire polarisée 32 de 500nm de côté, située au centre la zone de conversion Zc, espacée d'une distance de 500nm suivant les axes X et Y d'une zone élémentaire polarisée 32 périphérique de 250nm de largeur. Celle-ci est accolée à la bordure $Zc_b$ de la zone de conversion Zc. Ainsi, suivant l'axe X ou Y, la zone de conversion Zc comporte trois zones élémentaires polarisées 32 séparées deux à deux par une zone élémentaire non polarisée 33.

La force diélectrophorétique présente ainsi une variation spatiale dans la zone de conversion Zc qui est réduite par rapport à la variation illustrée sur la fig.2. Ainsi, le dépôt localisé des particules photoluminescentes p y est rendu plus uniforme. On améliore également le positionnement du plot de conversion P, dans la mesure où la zone de conversion Zc est maintenant distinguable vis-à-vis de la zone d'espacement Ze, en termes de force diélectrophorétique. Aussi, le plot de conversion P sera positionné correctement en regard de la diode D, et non plus à cheval de la bordure comme dans le cas de la fig.2.

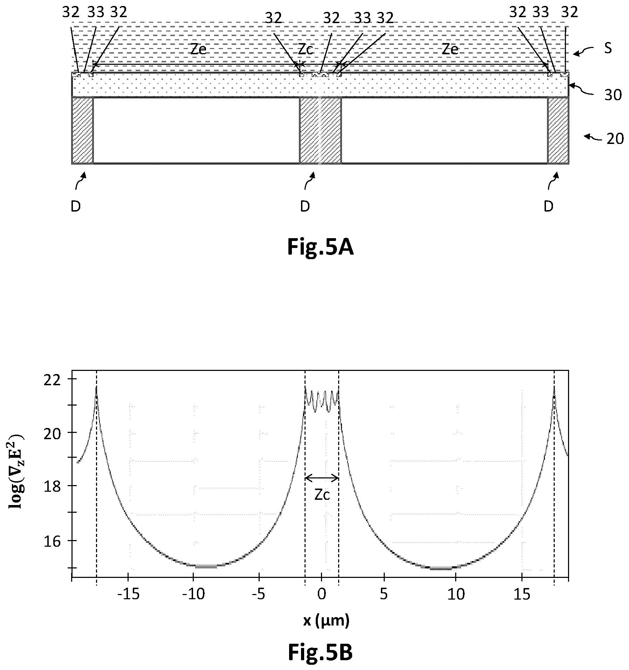

La figure 5A est une vue schématique et partielle, en coupe transversale, d'une matrice de diodes recouverte par une couche électret, laquelle est au contact d'une solution colloïdale. La figure 5B illustre la variation spatiale de l'intensité (en log) de la composante verticale $\nabla_z E^2$ du gradient de la norme au carré du champ électrique E, dont est proportionnelle la force diélectrophorétique F, calculée à une distance de 100nm au-dessus de la couche électret 30, dans la configuration structurelle de la fig.5A.

Dans cette configuration, les diodes D présentent une dimension latérale de $3\mu m$ et sont agencées périodiquement au pas de $19\mu m$. Aussi, les zones de conversion Zc présentent une dimension latérale de $3\mu m$ et sont espacées de $16\mu m$ les unes des autres. La couche électret 30 présente une permittivité relative homogène égale à 4, et la solution colloïdale S présente une permittivité relative homogène égale à 2.

Chaque zone de conversion Zc comporte une zone élémentaire polarisée 32 de 500nm de côté, située au centre la zone de conversion Zc, espacée suivant les axes X et Y d'une zone élémentaire polarisée 32 périphérique de 250nm de largeur. Celle-ci est accolée à la bordure $Zc_b$ de la zone de conversion Zc. Ainsi, suivant l'axe X ou Y, la zone de conversion Zc comporte trois zones élémentaires polarisées 32 séparées deux à deux par une zone élémentaire non polarisée 33.

La force diélectrophorétique présente ainsi une variation spatiale dans la zone de conversion Zc qui est réduite par rapport à la variation illustrée sur la fig.3B. Ainsi, le dépôt localisé des particules photoluminescentes p y est rendu plus uniforme. On améliore également le positionnement du plot de conversion P, dans la mesure où la zone de conversion Zc est maintenant distinguable vis-à-vis de la zone d'espacement Ze, en termes de force diélectrophorétique. Aussi, le plot de conversion P sera positionné correctement en regard de la diode D.

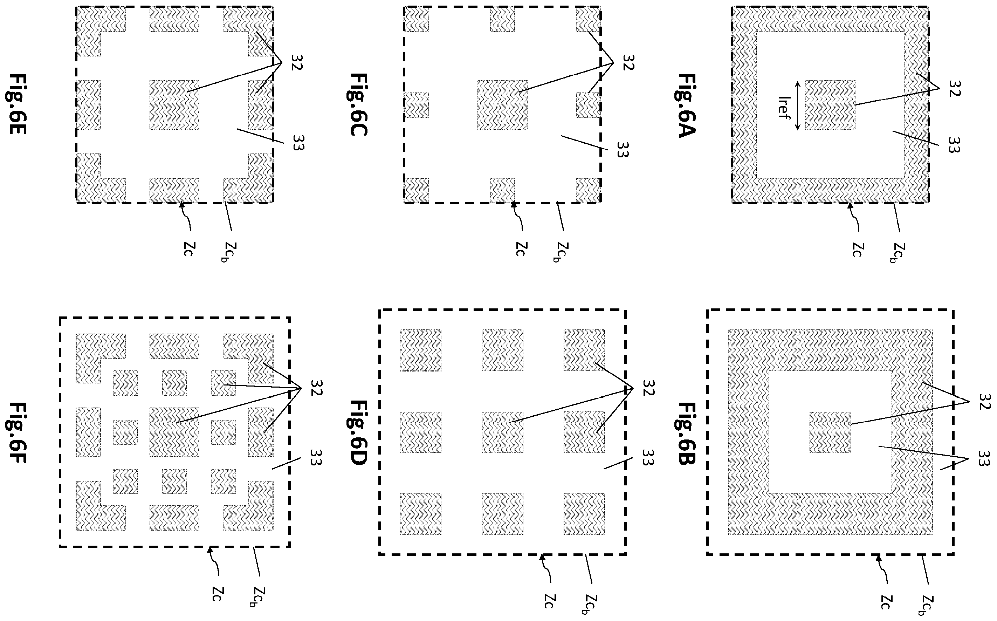

Les figures 6A à 6F sont des vues de dessus de différents exemples d'agencement des zones élémentaires polarisées 32 dans une zone de conversion Zc. Ces exemples sont donnés à titre illustratifs, étant entendu que d'autres agencements sont évidemment possibles. Ici, la zone de conversion Zc présente une forme de carré dans le plan XY, mais d'autres formes sont possibles (rectangulaire, polygonale, circulaire...)

La fig.6A illustre un agencement identique à celui de la fig.4B. La zone de conversion Zc comprend trois zones élémentaires polarisées 32 suivant l'axe X comme suivant l'axe Y. La zone élémentaire polarisée 32 centrale présente une largeur Iref, et la zone élémentaire polarisée 32 périphérique présente une largeur Iref/2. Celle-ci s'étend à partir de la bordure $Zc_b$ de la zone de conversion Zc, i.e. en étant accolée à la bordure. De plus, elle s'étend ici de manière continue le long de la bordure $Zc_b$. Par ailleurs, les zones élémentaires polarisées 32 sont espacées par une zone élémentaire non polarisée 33 de largeur Iref.

La fig.6B illustre un agencement qui diffère de celui de la fig.6A essentiellement en ce que la zone élémentaire polarisée 32 périphérique présente ici une largeur Iref égale à celle de la zone élémentaire polarisée 32 centrale. De plus, la zone élémentaire polarisée 32 périphérique n'est pas accolée à la bordure $Zc_b$, mais en est espacée par une zone élémentaire non polarisée 33 d'une largeur ici de Iref/2.

La fig.6C illustre un agencement qui diffère de celui de la fig.6A essentiellement en ce que des zones élémentaires polarisées 32 latérales distinctes les unes des autres sont réparties le long de la bordure, et entourent ainsi la zone élémentaire polarisée 32 centrale. Elles présentent ici une largeur Iref/2 et sont accolées à la bordure $Zc_b$.

La fig.6D illustre un agencement qui diffère de celui de la fig.6A essentiellement en ce que les zones élémentaires polarisées 32 latérales présentent une largeur Iref. Elles sont espacées les unes des autres, suivant l'axe X et l'axe Y, par une zone élémentaire non polarisée 33 de largeur Iref. Elles sont également espacées de la bordure, ici d'une largeur Iref/2.

La fig.6E illustre un agencement qui diffère de celui de la fig.6C essentiellement en ce que les zones élémentaires polarisées 32 latérales ne sont pas toutes identiques entre elles. Celles situées au sommet de la zone de conversion Zc ont une forme en L où les deux branches ont ici la même longueur Iref et une largeur Iref/2. Celles situées le long d'un côté de la zone de conversion Zc présentent une longueur Iref et une largeur Iref/2.

La fig.6F illustre un agencement qui différence de celui de la fig.6E essentiellement en ce que les zones élémentaires polarisées 32 latérales sont distantes de la bordure, ici d'une largeur Iref/2 suivant l'axe X et l'axe Y. De plus, des zones élémentaires polarisées 32 intermédiaires sont situées entre la zone élémentaire polarisée 32 centrale et les zones élémentaires polarisées 32 latérales suivant l'axe X et Y. Elles ont ici une forme de carré de côté Iref/2.

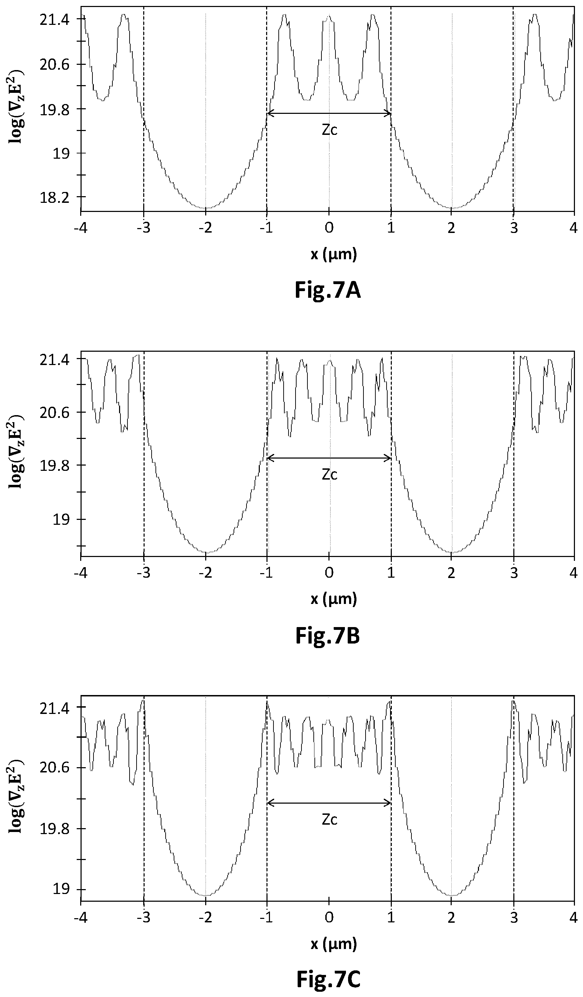

Les figures 7A à 7C illustrent une variation spatiale de l'intensité (en log) de la composante verticale $\nabla_z E^2$ du gradient de la norme au carré du champ électrique E, calculée à une distance de 100nm au-dessus de la couche électret 30, pour différents agencements des zones élémentaires polarisées 32 dans les zones de conversion Zc. Ici, les zones de conversion Zc ont une dimension de $2\mu m$ et sont espacées les unes des autres par une zone d'espacement de $2\mu m$. La couche électret 30 présente une permittivité relative homogène égale à 4, et la solution colloïdale présente une permittivité relative homogène égale à 2.

Sur la fig.7A, chaque zone de conversion Zc présente trois zones élémentaires polarisées 32 d'une largeur de 125nm, dont une zone 32 centrale et deux zones 32 latérales distantes de la bordure $Zc_b$. Le facteur de remplissage, suivant l'axe X, est ici de 19% (3x0.125/2). On remarque que la zone de conversion Zc est bien distinguable des zones d'espacement Ze, d'un point de vue de la force diélectrophorétique, ce qui améliore le positionnement du plot de conversion P ainsi que l'homogénéité d'épaisseur. De plus, le fait que les zones élémentaires polarisées 32 latérales soient distantes de la bordure permet de réduire l'intensité de la force diélectrophorétique, ce qui limite ainsi le dépôt des particules photoluminescentes p dans les zones d'espacement Ze, à proximité de la zone de conversion Zc, améliorant ainsi le contraste des pixels lumineux.

Sur la fig.7B, la zone de conversion Zc comprend cinq zones élémentaires polarisées 32 d'une largeur de 125nm. Les zones élémentaires polarisées 32 latérales sont distantes de la bordure. On remarque que cette configuration permet d'améliorer davantage le positionnement du plot de conversion P en regard de la diode, d'améliorer l'uniformité d'épaisseur du plot de conversion P, et de limiter le dépôt des particules photoluminescentes p dans les zones d'espacement Ze, à proximité de la zone de conversion Zc.

Sur la fig.7C, la zone de conversion Zc comprend sept zones élémentaires polarisées 32 d'une largeur de 125nm. Les zones élémentaires polarisées 32 latérales sont accolées à la bordure. Si l'on améliore encore le positionnement du plot de conversion P en regard de la diode et l'uniformité d'épaisseur du plot de conversion P, on remarque que la présence des zones élémentaires polarisées 32 latérales accolées à la bordure peut conduire à un dépôt des particules photoluminescentes p dans les zones d'espacement Ze à proximité de la bordure de la zone de conversion Zc.

Selon un mode de réalisation, la couche électret peut être formée de plusieurs portions de matériaux ayant une permittivité relative différente.

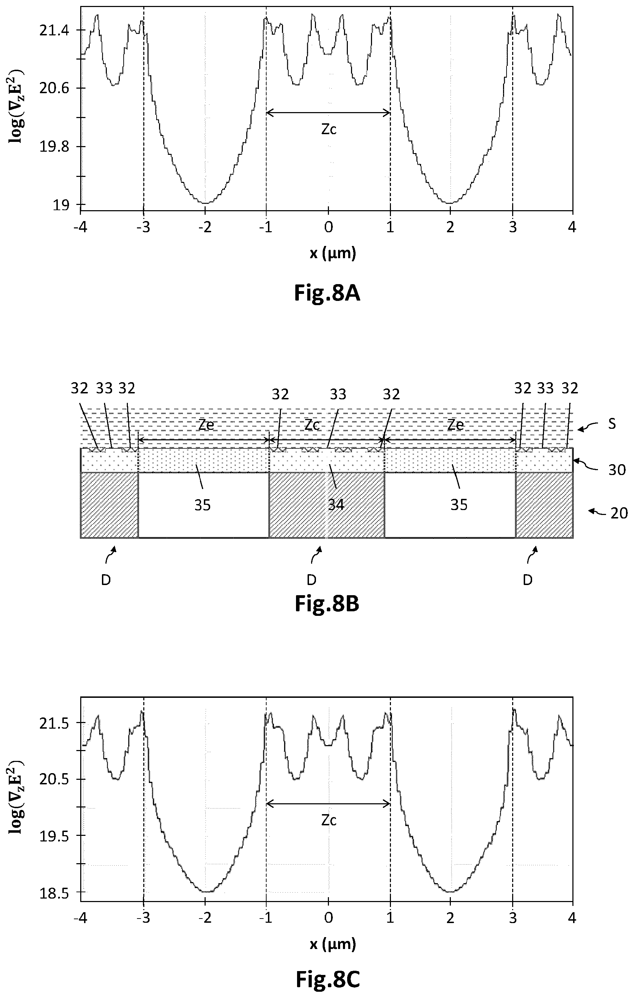

A ce titre, les figures 8A à 8C illustrent une comparaison entre une configuration où la couche électret est homogène, i.e. présentant une même valeur de permittivité relative partout dans la couche électret, et une configuration où la couche électret n'est pas homogène en termes de permittivité relative.

On considère tout d'abord une configuration où la couche électret présente une permittivité relative constante (uniforme) dans toute la couche.

La figure 8A illustre une variation spatiale de l'intensité (en log) de la composante verticale $\nabla_z E^2$ du gradient de la norme au carré du champ électrique E, calculée à une distance de 100nm au-dessus de la couche électret 30, pour une configuration où la couche électret est homogène (permittivité relative constante partout dans la couche).

Dans cette configuration, les diodes présentent une dimension latérale de $2\mu m$ et sont agencées périodiquement au pas de $4\mu m$. Aussi, les zones de conversion Zc présentent une dimension latérale de $2\mu m$ et sont espacées de $2\mu m$ les unes des autres. La couche électret présente une permittivité relative uniforme égale à 4, et la solution colloïdale présente une permittivité relative uniforme égale à 2. La zone de conversion Zc est structurée de manière à former quatre zones élémentaires polarisées 32 suivant l'axe X.

La figure 8B est une vue schématique et partielle, en coupe transversale, d'une matrice de diodes 20 recouverte par une couche électret 30 et une solution colloïdale S.

La configuration est similaire à celle décrite en référence à la fig.8A, et en diffère seulement en ce que la couche électret 30 n'est pas homogène, mais est formée d'une succession de portions 34, 35 distinctes présentant des permittivités relatives différentes. Ainsi, les portions 34 en regard des diodes présentent ici une permittivité relative de 4 et sont réalisées en un matériau dit low-k, par exemple un oxyde ou nitrure de silicium. Les portions 35 situées entre les diodes présentent une permittivité relative élevée, ici égale à 20, et sont réalisées en un matériau dit high-k, par exemple un oxyde de titane ou de tantale.

La figure 8C illustre une variation spatiale de l'intensité (en log) de la composante verticale $\nabla_z E^2$ du gradient de la norme au carré du champ électrique E, calculée à une distance de 100nm au-dessus de la couche électret 30, pour la configuration de la fig.8B. On remarque que la variation est similaire, cependant elle présente un minimum plus important dans les zones d'espacement Ze, ici de 18.5 au lieu de 19 dans le cas de la fig.8A. Aussi, on réduit les risques de dépôt des particules photoluminescentes p dans les zones d'espacement Ze, et le dépôt a lieu davantage dans les zones de conversion Zc.

Selon un autre mode de réalisation, ne faisant pas partie de la présente invention telle que définie par les revendications en annexe mais étant utile pour comprendre son contexte, les zones de conversion Zc peuvent ne pas être structurées et peuvent donc présenter un potentiel de surface uniformément non nul. Dans ce cas, on définit une permittivité relative aux zones de conversion Zc et aux zones d'espacement Ze.

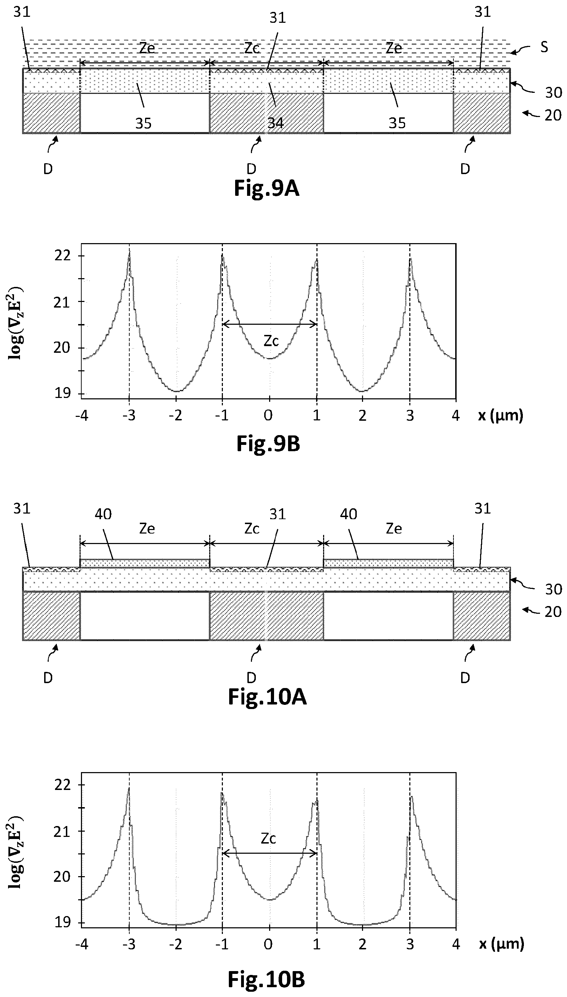

Comme l'illustre la fig.9A, dans le cas où la couche électret 30 est inhomogène et est formée d'une succession de portions 34, 35 de matériaux ayant une permittivité relative différente, la permittivité relative des zones de conversion Zc est égale à celle des portions 34, et la permittivité relative des zones d'espacement Ze est égale à celle des portions 35. Comme indiqué précédemment, les portions 34 sont réalisées en un matériau low-k, par exemple un oxyde ou un nitrure de silicium, et les portions 35 sont réalisées en un matériau high-k, par exemple un oxyde de titane ou tantale.

Comme l'illustre la fig.9B, la variation de la force diélectrophérétique, ici le log de $\nabla_z E^2$, n'est pas identique dans les zones de conversion Zc et dans les zones d'espacement Ze. En effet, le minimum dans les zones de conversion Zc est plus élevé que dans les zones d'espacement Ze. Aussi, les particules photoluminescentes p se déposeront de manière privilégiée dans les zones de conversion Zc plutôt que dans les zones d'espacement Ze.

Comme l'illustre la fig.10A, la couche électret 30 est inhomogène et est formée d'une sous-couche formée d'un même matériau à permittivité relative constante, ici un matériau low-k, et de portions 40 en un matériau dit very high-k, dont la permittivité relative est égale à au moins 100, recouvre uniquement les zones d'espacement Ze et non pas les zones de conversion Zc. Ces portions sont réalisées par exemple en un matériau pérovskite et/ou ferroélectriques, en BaSrTiO3,

# EP 4 572 574 B1

BaTiO3, SrTiO3, PbZrTiO3, KNN, entre autres. La permittivité relative peut être égale à 250. Aussi, la permittivité relative des zones de conversion Zc est égale à celle de la sous-couche de la couche électret (par ex : 4), et la permittivité relative des zones d'espacement Ze est égale à celle des portions 40 (par ex : 250).

Comme l'illustre la fig.10B, la variation de la force diélectrophorétique, ici le log de $\nabla_z E^2$, n'est pas non plus identique dans les zones de conversion Zc et dans les zones d'espacement Ze. En effet, le minimum dans les zones de conversion Zc est plus élevé que dans les zones d'espacement Ze, et celles-ci présentent une valeur minimale sur une plus grande surface. Aussi, les particules photoluminescentes p se déposeront de manière privilégiée dans les zones de conversion Zc plutôt que dans les zones d'espacement Ze.

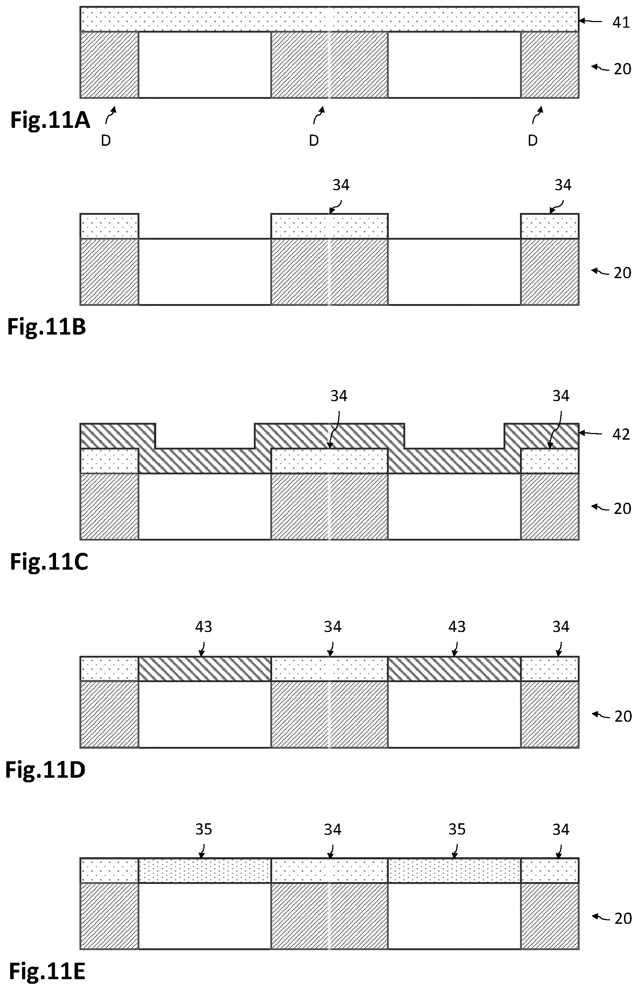

Les figures 11A à 11E illustrent un exemple d'un procédé de réalisation d'une couche électret formée d'une succession de plusieurs portions ayant des permittivités relatives différentes, ici des portions ayant une même permittivité relative faible, et des portions ayant une même permittivité relative élevée.

On peut ainsi déposer une couche électret 41 formée du matériau low-k, qui recouvre toute la matrice de diodes 20 (fig.11A). Puis, on réalise des ouvertures traversantes débouchant sur la matrice de diodes 20, pour former des portions 34 situées en regard des diodes (fig.11B). Les ouvertures sont ici traversantes, mais elles pourraient ne pas l'être. On dépose ensuite une couche 42 formée d'un matériau high-k, ou ici un matériau métallique tel que du Ti ou Ta, de manière à recouvrir la matrice de diodes 20 et les portions 34 (fig.11C). Puis, on réalise une planarisation mécano-chimique avec un arrêt sur les portions 34 (fig.11D). Enfin, on effectue un recuit d'oxydation du métal pour obtenir le matériau high-k des portions 35, ici un oxyde de Ti ou Ta (fig.11E).

Des modes de réalisation particuliers viennent d'être décrits. Différentes variantes et modifications apparaîtront à l'homme du métier. L'étendue de la présente invention est définie par les revendications qui suivent.


## Revendications

1.   Procédé de fabrication d'un dispositif optoélectronique, comportant les étapes suivantes :

   ∘ fournir une matrice (20) de diodes (D), présentant une face avant destinée à recevoir ou transmettre un rayonnement lumineux ;
   ∘ réaliser une couche électret (30), s'étendant sur la face avant de la matrice (20) de diodes (D), dont une face supérieure, opposée à la face avant, présente des zones de conversion (Zc), chacune étant située à la perpendiculaire d'une diode (D) et destinée à être recouverte par un plot (P) de conversion de couleur, séparées deux à deux par une zone d'espacement (Ze) à potentiel de surface nul ;
   ∘ réaliser les plots (P) de conversion de couleur, par mise en contact de la couche électret (30) avec une solution colloïdale (S) contenant des particules photoluminescentes (p), lesquelles se déposent sur la couche électret (30) dans les zones de conversion (Zc), formant ainsi les plots (P) de conversion de couleur ;

   **caractérisé en ce que**, à la suite de l'étape de réalisation de la couche électret (30), chaque zone de conversion (Zc) est formée d'une pluralité de zones élémentaires dites polarisées (32) à potentiel de surface non nul espacées deux à deux par une zone élémentaire dite non polarisée (33) à potentiel de surface nul, de sorte que la zone de conversion (Zc) présente un potentiel de surface structuré.

2.   Procédé de fabrication selon la revendication 1, dans lequel les zones élémentaires polarisées (32) sont agencées de manière symétrique vis-à-vis d'un centre de la zone de conversion (Zc).

3.   Procédé de fabrication selon la revendication 1 ou 2, dans lequel chaque zone de conversion (Zc) comporte entre trois et neuf zones élémentaires polarisées (32), et de préférence entre trois et sept zones élémentaires polarisées (32).

4.   Procédé de fabrication selon l'une quelconque des revendications 1 à 3, dans lequel les zones élémentaires polarisées (32) sont toutes situées à distance d'une bordure (Zc_b) de la zone de conversion (Zc).

5.   Procédé de fabrication selon l'une quelconque des revendications 1 à 4, dans lequel la couche électret (30) présente une permittivité relative homogène.

6.   Procédé de fabrication selon l'une quelconque des revendications 1 à 4, dans lequel la couche électret (30) présente une permittivité relative présentant une première valeur dans les zones de conversion (Zc) et une deuxième valeur supérieure à la première valeur hors des zones de conversion (Zc).

7.   Procédé de fabrication selon la revendication 6, dans lequel la couche électret (30) est formée de premières portions situées dans les zones de conversion (Zc) et réalisées en un matériau présentant la première valeur de permittivité relative, et des deuxièmes portions situées hors des zones de conversion (Zc) et réalisées en un matériau présentant la deuxième valeur de permittivité relative.

8. Procédé de fabrication selon la revendication 6, dans lequel la couche électret (30) est formée d'une sous-couche continue recouvrant la matrice de diodes et réalisée en un matériau présentant la première valeur de permittivité relative, et de portions (40) recouvrant la sous-couche, situées hors des zones de conversion (Zc) et réalisées en un matériau présentant la deuxième valeur de permittivité relative.

9. Dispositif optoélectronique, comportant :

   ○ une matrice (20) de diodes (D) présentant une face avant destinée à recevoir ou transmettre un rayonnement lumineux ;
   ○ une couche électret (30), s'étendant sur la face avant de la matrice (20) de diodes (D), dont une face supérieure, opposée à la face avant, présente des zones de conversion (Zc), chacune étant située à la perpendiculaire d'une diode (D) et destinée à être recouverte par un plot (P) de conversion de couleur, séparées deux à deux par une zone d'espacement (Ze) à potentiel de surface nul ;
   ○ des plots (P) de conversion de couleur, situés sur la couche électret (30) et positionnés dans les zones de conversion (Zc) ;

   **caractérisé en ce que**, chaque zone de conversion (Zc) est formée d'une pluralité de zones élémentaires dites polarisées (32) à potentiel de surface non nul espacées deux à deux par une zone élémentaire dite non polarisée (33) à potentiel de surface nul, de sorte que la zone de conversion (Zc) présente un potentiel de surface structuré.

10. Dispositif optoélectronique selon la revendication précédente, dans lequel les diodes (D) présentent des propriétés d'émission ou d'absorption d'un rayonnement lumineux identiques entre elles.

11. Dispositif optoélectronique selon la revendication 9 ou 10, dans lequel les diodes (D) sont réalisées à base d'un composé semiconducteur organique ou inorganique.

**Patentansprüche**

1. Verfahren zur Herstellung einer optoelektronischen Vorrichtung, das die folgenden Schritte aufweist:

   ○ Bereitstellen einer Matrix (20) von Dioden (D), die eine Vorderseite aufweist, die zum Empfangen oder Übertragen einer Lichtstrahlung bestimmt ist;
   ○ Herstellen einer Elektretschicht (30), die sich auf der Vorderseite der Matrix (20) aus Dioden (D) erstreckt, wobei eine der Vorderseite gegenüberliegende Oberseite Umwandlungsbereiche (Zc) aufweist, die jeweils senkrecht zu einer Diode (D) angeordnet sind und dazu bestimmt sind, von einem Farbumwandlungsfleck (P) bedeckt zu werden, wobei sie paarweise durch einen Abstandsbereich (Ze) mit Null-Oberflächenpotential voneinander getrennt sind;
   ○ Herstellen der Farbumwandlungsflecke (P) durch Inkontaktversetzen der Elektretschicht (30) mit einer kolloidalen Lösung (S), die photolumineszierende Partikel (p) enthält, die sich auf der Elektretschicht (30) in den Umwandlungsbereichen (Zc) absetzen und so die Farbumwandlungsflecke (P) bilden;

   **dadurch gekennzeichnet, dass** infolge des Herstellungsschritts der Elektretschicht (30) jeder Umwandlungsbereich (Zc) aus einer Vielzahl als polarisiert bezeichneten Elementarbereichen (32) mit Null-Oberflächenpotenzial gebildet wird, die paarweise durch einen als nicht polarisiert bezeichneten Elementarbereich (33) mit Null-Oberflächenpotenzial beabstandet sind, so dass der Umwandlungsbereich (Zc) ein strukturiertes Oberflächenpotenzial aufweist.

2. Herstellungsverfahren nach Anspruch 1, wobei die polarisierten Elementarbereiche (32) symmetrisch zu einem Mittelpunkt des Umwandlungsbereichs (Zc) eingerichtet sind.

3. Herstellungsverfahren nach Anspruch 1 oder 2, wobei jeder Umwandlungsbereich (Zc) zwischen drei und neun polarisierte Elementarbereiche (32) und vorzugsweise zwischen drei und sieben polarisierte Elementarbereiche (32) aufweist.

**4.** Herstellungsverfahren nach einem der Ansprüche 1 bis 3, wobei die polarisierten Elementarbereiche (32) alle in einem Abstand von einer Kante ($Zc_b$) des Umwandlungsbereichs (Zc) liegen.

**5.** Herstellungsverfahren nach einem der Ansprüche 1 bis 4, wobei die Elektretschicht (30) eine homogene relative Permittivität aufweist.

**6.** Herstellungsverfahren nach einem der Ansprüche 1 bis 4, wobei die Elektretschicht (30) eine relative Permittivität aufweist, die einen ersten Wert in den Umwandlungsbereichen (Zc) und einen zweiten Wert, der größer ist als der erste Wert, außerhalb der Umwandlungsbereiche (Zc) aufweist.

**7.** Herstellungsverfahren nach Anspruch 6, wobei die Elektretschicht (30) aus ersten Abschnitten gebildet ist, die sich in den Umwandlungsbereichen (Zc) befinden und aus einem Material hergestellt sind, das den ersten relativen Permittivitätswert aufweist, und aus zweiten Abschnitten, die sich außerhalb der Umwandlungsbereiche (Zc) befinden und aus einem Material hergestellt sind, das den zweiten relativen Permittivitätswert aufweist.

**8.** Herstellungsverfahren nach Anspruch 6, wobei die Elektretschicht (30) aus einer durchgehenden Unterschicht gebildet ist, die die Diodenmatrix bedeckt und aus einem Material hergestellt ist, das den ersten relativen Permittivitätswert aufweist und aus Abschnitten (40), die die Unterschicht bedecken, die sich außerhalb der Umwandlungsbereiche (Zc) befinden und aus einem Material hergestellt sind, das den zweiten relativen Permittivitätswert aufweist.

**9.** Optoelektronische Vorrichtung, die aufweist:

◦ eine Matrix (20) von Dioden (D), die eine Vorderseite aufweist, die zum Empfangen oder Übertragen einer Lichtstrahlung bestimmt ist;
◦ eine Elektretschicht (30), die sich auf der Vorderseite der Matrix (20) von Dioden (D) erstreckt, wobei eine der Vorderseite gegenüberliegende Oberseite Umwandlungsbereiche (Zc) aufweist, die jeweils senkrecht zu einer Diode (D) angeordnet sind und dazu bestimmt sind, von einem Farbumwandlungsfleck (P) bedeckt zu werden, wobei sie paarweise durch einen Abstandsbereich (Ze) mit Null-Oberflächenpotenzial voneinander getrennt sind;
◦ Farbumwandlungsflecke (P), die sich auf der Elektretschicht (30) befinden und in den Umwandlungsbereichen (Zc) positioniert sind;

**dadurch gekennzeichnet, dass** jeder Umwandlungsbereich (Zc) aus einer Vielzahl als polarisiert bezeichneten Elementarbereichen (32) mit Null-Oberflächenpotenzial gebildet wird, die paarweise durch einen als nicht polarisiert bezeichneten Elementarbereich (33) mit Null-Oberflächenpotenzial beabstandet sind, so dass der Umwandlungsbereich (Zc) ein strukturiertes Oberflächenpotenzial aufweist.

**10.** Optoelektronische Vorrichtung nach vorstehendem Anspruch, wobei die Dioden untereinander identische Eigenschaften zur Emission oder Absorption einer Lichtstrahlung aufweisen.

**11.** Optoelektronische Vorrichtung nach Anspruch 9 oder 10, wobei die Dioden auf Grundlage einer organischen oder anorganischen Halbleiterverbindung hergestellt sind.

**Claims**

**1.** A method for manufacturing an optoelectronic device (1), including the following steps:

◦ providing a diode array (20), having a front face intended to receive or transmit light radiation;
◦ producing an electret layer (30), extending on the front face of the diode array (20), an upper face of which, opposite the front face, has conversion zones (Zc), each being situated perpendicular to a diode (D) and intended to be covered by a color conversion pad (P), separated two-by-two by a spacing zone (Ze) with zero surface potential;
◦ producing the color conversion pads (P), by placing the electret layer (30) in contact with a colloidal solution (S) containing photoluminescent particles (p), which are deposited on the electret layer (30) in the conversion zones (Zc), thus forming the color conversion pads (P);

**characterized in that**, following the step of producing the electret layer (30), each conversion zone (Zc) is formed of a plurality of so-called polarized elementary zones (32) with non-zero surface potential, spaced apart two-by-two by a so-called non-polarized elementary zone (33) with zero surface potential, such that the conversion zone (Zc) has a structured surface potential.

2. The manufacturing method according to claim 1, wherein the polarized elementary zones (32) are symmetrically arranged with respect to a center of the conversion zone (Zc).

3. The manufacturing method according to claim 1 or 2, wherein each conversion zone (Zc) includes between three and nine polarized elementary zones (32), and preferably between three and seven polarized elementary zones (32).

4. The manufacturing method according to any one of claims 1 to 3, wherein the polarized elementary zones (32) are all situated at a distance from a border ($Zc_b$) of the conversion zone (Zc).

5. The manufacturing method according to any one of claims 1 to 4, wherein the electret layer (30) has a homogeneous relative permittivity.

6. The manufacturing method according to any one of claims 1 to 4, wherein the electret layer (30) has a relative permittivity having a first value in the conversion zones (Zc) and a second value greater than the first value outside of the conversion zones (Zc).

7. The manufacturing method according to claim 6, wherein the electret layer (30) is formed of first portions situated in the conversion zones (Zc) and made of a material having the first relative permittivity value, and second portions situated outside of the conversion zones (Zc) and made of a material having the second relative permittivity value.

8. The manufacturing method according to claim 6, wherein the electret layer (30) is formed of a continuous sublayer covering the diode array and made of a material having the first relative permittivity value, and portions (40) covering the sublayer, situated outside of the conversion zones (Zc) and made of a material having the second relative permittivity value.

9. An optoelectronic device (1), including:

  ∘ a diode array (20) having a front face intended to receive or transmit light;
  ∘ an electret layer (30), extending on the front face of the diode array (20), an upper face of which, opposite the front face, has conversion zones (Zc), each being situated perpendicular to a diode (D) and intended to be covered by a color conversion pad (P), separated two-by-two by a spacing zone (Ze) with zero surface potential;
  ∘ color conversion pads (P), situated on the electret layer (30) and positioned in the conversion zones (Zc);

  **characterized in that** each conversion zone (Zc) is formed of a plurality of so-called polarized elementary zones (32) with non-zero surface potential spaced apart two-by-two by a so-called non-polarized elementary zone (33) with zero surface potential, such that the conversion zone (Zc) has a structured surface potential.

10. The optoelectronic device (1) according to the preceding claim, wherein the diodes (D) have light emission or absorption properties identical to one another.

11. The optoelectronic device (1) according to claim 9 or 10, wherein the diodes are made from an organic or inorganic semiconductor compound.

**Fig.1A**

**Fig.1B**

**Fig.1C**

**Fig.2**

**Fig.3A**

**Fig.3B**

**Fig.4A**

**Fig.4B**

**Fig.4C**

**Fig.5A**

**Fig.5B**

32    33

Zc$_b$

Zc

lref

**Fig.6A**

32    33

Zc$_b$

Zc

**Fig.6B**

32    33

Zc$_b$

Zc

**Fig.6C**

32    33

Zc$_b$

Zc

**Fig.6D**

32    33

Zc$_b$

Zc

**Fig.6E**

32    33

Zc$_b$

Zc

**Fig.6F**

**Fig.7A**

**Fig.7B**

**Fig.7C**

**Fig.8A**

**Fig.8B**

**Fig.8C**

Fig.9A

Fig.9B

Fig.10A

Fig.10B

**Fig.11A**

D         D         D

41

20

**Fig.11B**

34         34

20

**Fig.11C**

34         34

42

20

**Fig.11D**

43    34    43    34

20

**Fig.11E**

35    34    35    34

20

# EP 4 572 574 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014136023 A1
- WO 2021023656 A1
- DE 102004021231 A1
- WO 2017194845 A1
- FR 2308637
- FR 2309260